# FASCICULE DE BREVET EUROPEEN

(11) **EP 3 526 661 B1**
(45) Date de publication et mention de la délivrance du brevet: **01.12.2021**
(21) Numéro de dépôt: 17797389.8
(22) Date de dépôt: 12.10.2017
(51) Int. Cl.: G06F 3/044, B60K 37/06, G06F 3/0354, H05K 1/11

(54) **INTERFACE ELECTRONIQUE DE SAISIE A DETECTION CAPACITIVE**
KAPAZITIVE-MESSENDE ELEKTRONISCHE EINGABESCHNITTSTELLE
CAPACITIVE-SENSING ELECTRONIC INPUT INTERFACE

(30) Priorité: 14.10.2016 FR 1660001
(43) Date de publication de la demande: 21.08.2019
(73) Titulaire: Renault S.A.S., 92100 Boulogne-Billancourt (FR)
(72) Inventeur: LIPS, Mathieu, 78280 Guyancourt (FR); REYSS, Bertrand, 91400 Orsay (FR)
(86) Numéro de dépôt international: PCT/FR2017/052815
(87) Numéro de publication internationale: WO 2018/069657

(56) Documents cités:
- DE-A1-102006 041 271
- DE-A1-102009 058 592
- FR-A1- 3 001 488
- FR-A1- 3 039 792

## Description

### DOMAINE TECHNIQUE AUQUEL SE RAPPORTE L'INVENTION

La présente invention concerne de manière générale les interfaces homme-machine.

Elle concerne plus particulièrement une interface électronique de saisie, comprenant :
- un socle diélectrique dont une face est accessible à l'usager, et
- un détecteur capacitif qui est situé à distance de ladite face et qui comprend au moins deux antennes distinctes.

Elle concerne également un procédé de fabrication d'une telle interface.

### ARRIERE-PLAN TECHNOLOGIQUE

Parmi les interfaces homme-machine, certaines sont basées sur une technologie de détection capacitive d'objet.

De manière très générale, cette technologie consiste à utiliser deux antennes, qui forment ensemble une sorte de condensateur. Chacune de ces antennes est prévue pour former, avec un objet (métallique ou non) que l'on approcherait d'elles, un autre condensateur.

L'utilisation d'un circuit électronique connecté à ces antennes et alimenté judicieusement permet alors de détecter des variations électriques lorsqu'un objet (par exemple la main d'un usager) s'approche des antennes. Il s'avère alors possible, compte tenu des mesures effectuées, de suivre le mouvement de la main de l'usager et de commander en fonction de ces mouvements une fonctionnalité d'un quelconque appareil électrique.

En pratique, les antennes sont généralement réalisées sur un substrat flexible qui est ensuite fixé à l'arrière d'un bouton en matière plastique, par exemple par collage.

Afin d'assurer un bon maintien du substrat flexible à l'arrière du bouton et une bonne détection de la main d'un usager, il est nécessaire d'assembler le substrat flexible au bouton avec soin. La forme du bouton doit en outre rester relativement simple (la plus plate possible), de manière à ce que la fixation résiste aux conditions d'utilisation du bouton. La colle utilisée doit quant à elle résister aux conditions de température auxquelles le bouton est soumis. Une telle interface s'avère donc onéreuse à fabriquer.

Il est connu d'utiliser pour interface homme-machine des touches de clavier tel que décrit dans le document DE102006041271 qui divulgue un dispositif de commande pourvu d'un clavier, d'un cadre plastique, d'un bouchon de connexion à un module externe et d'un boitier sur le fond duquel est surmoulé un circuit, la connexion électrique du clavier avec le circuit se faisant par l'intermédiaire de composants tels que des ressorts ou des broches.

Selon une autre technologie, le document FR3001488 divulgue un ensemble de verrouillage et de déverrouillage d'un ouvrant qui comprend un circuit électrique comprenant des pistes conductrices surmoulées dans un support, destiné à alimenter un actionneur électrique permettant l'actionnement d'une trappe par pression.

Enfin, le document DE102009058592 décrit un détecteur capacitif pour véhicule automobile, permettant de repérer dans l'espace la main d'un usager. Ce détecteur comporte un socle en matière plastique sur lequel sont disposés des éléments de détection obtenus par métallisation. Les éléments de détection sont connectés à un circuit imprimé déporté, relié aux éléments de détection au moyen des éléments de contact, ne permettant pas un fonctionnement robuste et précis, adaptable à toute surface tel qu'une coque creuse de volant, à un coût peu onéreux.

### OBJET DE L'INVENTION

La présente invention propose alors de simplifier et de fiabiliser la fabrication de l'interface électronique de saisie.

Plus particulièrement, on propose selon l'invention une interface électronique de saisie telle que définie dans l'introduction, dans laquelle le socle diélectrique et les deux antennes forment ensemble un « dispositif d'interconnexion moulé ».

La technologie MID (de l'anglais « molded interconnected device » ou « dispositif d'interconnexion moulé ») est une technologie qui permet d'unir les fonctions mécaniques et électroniques d'objets tridimensionnels en un seul élément monobloc et indémontable. Le résultat est un circuit électrique dont le substrat est formé par le socle diélectrique lui-même.

Cette technologie consiste en pratique à réaliser les fonctions mécaniques et électroniques ensemble, par une technique d'injection d'une matière thermoplastique dopée puis de métallisation d'une partie de la surface de la pièce obtenue.

L'application de cette technologie aux interfaces électroniques de saisie permet alors de se passer de substrat pour les antennes, le socle diélectrique étant utilisé comme substrat et l'étape de métallisation permettant d'appliquer sur ce socle les deux antennes du détecteur capacitif. Plus particulièrement, le détecteur capacitif comprend un circuit électronique qui est connecté auxdites deux antennes et qui est adapté à élaborer un signal de détection d'objet ; et une partie au moins dudit circuit électronique forme avec le socle diélectrique et les deux antennes un dispositif d'interconnexion moulé.

Ce procédé permet donc non seulement de faciliter la fabrication de l'interface, mais aussi d'assurer un positionnement relatif de ses composants qui est très précis, ce qui garantie un bon fonctionnement de l'interface.

Puisque le socle thermoplastique peut être facilement réalisé en trois dimensions et que le circuit électrique peut être déposé sur une surface de forme quelconque, il est possible de créer une interface de n'importe quelle forme, par exemple de forme intuitive pour l'usager (le geste à réaliser pour commander la fonction souhaitée étant suggéré par la forme de l'interface).

L'interface obtenue présente en outre un faible encombrement, de sorte qu'elle peut être facilement intégrée dans un quelconque ensemble, par exemple dans un véhicule automobile.

Enfin, la fabrication en série de l'interface au moyen de cette technologie s'avère peu onéreux.

A ce stade, on notera que l'expression « le socle diélectrique et les deux antennes forment ensemble un dispositif d'interconnexion moulé » signifie que le socle diélectrique est au moins en partie réalisé dans une matière thermoplastique dopée en agents facilitant la métallisation, et que les deux antennes sont obtenues par métallisation d'une partie au moins de la surface de cette matière thermoplastique dopée.

D'autres caractéristiques avantageuses et non limitatives de l'interface électronique de saisie conforme à l'invention sont les suivantes :
- la face du socle diélectrique qui est accessible à l'usager présente une forme tridimensionnelle ;
- la face du socle diélectrique qui est accessible à l'usager présente une forme ondulée.

L'invention porte également sur un véhicule automobile comprenant une interface électronique de saisie telle que précitée.

Préférentiellement, le véhicule automobile comprend un actionneur permettant de commander la levée et la descente d'une vitre ou la position d'un siège ou la température émise par une climatisation, qui est piloté au moyen de ladite interface électronique de saisie.

L'invention propose aussi un procédé de fabrication d'une interface électronique de saisie, qui comprend la réalisation d'un socle diélectrique et de deux antennes de détecteur capacitif via une technologie de fabrication de dispositif d'interconnexion moulé, laquelle technologie comprend une étape d'injection d'une pièce moulée en matière thermoplastique dopée, et une étape de métallisation de ladite pièce moulée, procédé dans lequel une partie au moins d'un circuit électronique qui est connecté auxdites deux antennes et qui est adapté à élaborer un signal de détection d'objet est réalisée avec le socle diélectrique et les deux antennes via la technologie de fabrication de dispositif d'interconnexion moulé.

Avantageusement alors, il est prévu une étape d'assemblage de composants électroniques et d'un connecteur sur ledit circuit électronique.

L'étendue de l'objet de l'invention est définie par les revendications annexées.

### DESCRIPTION DETAILLEE D'UN EXEMPLE DE REALISATION

La description qui va suivre en regard du dessin annexé, donné à titre d'exemple non limitatif, fera bien comprendre en quoi consiste l'invention et comment elle peut être réalisée.

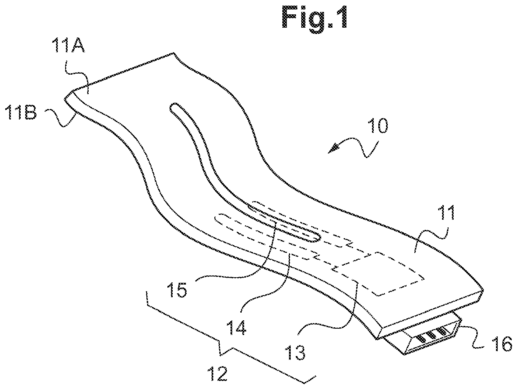

Sur le dessin annexé, la figure 1 est une vue schématique en perspective d'une interface électronique de saisie.

Il s'agit d'une interface homme-machine, c'est-à-dire d'un objet permettant à un usager de communiquer un ordre à un quelconque appareil.

Cette interface 10 pourra être utilisée dans le domaine automobile, par exemple pour permettre à un usager de commander un moteur de positionnement de fauteuil ou un compresseur de climatisation, ...

Elle pourra également être utilisée dans d'autres domaines (électroménager, domotique, ...).

Ici, on considérera qu'elle sera utilisée pour commander un moteur lève-vitre de véhicule automobile.

Cette interface 10 est exclusivement constituée de composants immobiles et rigides.

Elle comporte plus précisément un socle diélectrique 11 et un détecteur capacitif 12. Elle est ainsi conçue pour repérer la position du doigt d'un usager venant s'appuyer sur elle, par un système de détection capacitive.

Le socle diélectrique 11 présente une forme tridimensionnelle, conçue pour suggérer à l'usager de manière intuitive la manière selon laquelle il faut l'utiliser pour commander la fonctionnalité associée à l'interface 10.

Ici, ce socle diélectrique 11 se présente sous la forme d'une plaque ondulée en forme de vagues se succédant selon un axe longitudinal, ce qui suggère à l'usager de faire glisser son doigt selon cet axe longitudinal pour monter ou descendre la vitre du véhicule.

En variante, le socle diélectrique 11 pourrait présenter une forme différente, compte tenu de la fonctionnalité à commander.

Comme le montre bien la figure 1, le socle diélectrique 11 présente une face externe 11A qui est accessible au doigt de l'usager, et une face interne 11B opposée.

Le détecteur capacitif 12 est alors ici situé sur cette face interne 11B. Il comprend deux antennes 14, 15 distinctes, et un circuit électronique 13 qui est connecté à ces deux antennes 14, 15.

Les antennes 14, 15 sont formées par des pistes conductrices s'étendant sur la face interne 11B du socle diélectrique 11. Elles peuvent présenter des formes diverses. A titre d'exemple, elles peuvent se présenter sous la forme de bandes rectangulaires parallèles à l'axe longitudinal.

Le circuit électronique 13 étant bien connu de l'homme du métier, il ne sera pas ici décrit en détail.

On précisera seulement qu'il comporte des pistes conductrices et des composants électroniques (résistances, condensateurs, ...) et qu'il est conçu pour élaborer un signal de détection d'objet (notamment de détection de la position du doigt de l'usager qui s'appuie sur le socle diélectrique 11).

Ce circuit électronique 13 est à cet effet connecté, d'une part, aux deux antennes 14, 15, et, d'autre part, à un bornier 16.

Ce bornier 16 permet d'alimenter le circuit électronique 13 par un signal alternatif à fréquence fixe, de façon à ce que ce circuit électronique 13 puisse détecter des variations des propriétés électriques du système lorsque le doigt de l'usager glisse sur le socle diélectrique 11.

Ce bornier 16 permet d'autre part de communiquer le signal de détection d'objet à un calculateur qui pourra alors commander le moteur lève-vitre en fonction de ce signal.

L'invention porte plus précisément sur la manière selon laquelle l'interface 10 est obtenue.

Pour fabriquer cette interface 10, on emploie selon l'invention la technologie MID (de l'anglais « molded interconnected device ») de façon à unir les fonctions mécaniques (le support diélectrique 11) et électroniques (les antennes 14, 15) de l'interface 10 en un seul élément.

Cette technologie peut être mise en œuvre de diverses manières.

Généralement, sa mise en œuvre comporte au moins une étape d'injection d'une pièce moulée en matière thermoplastique dopée pour former le support diélectrique 11, une étape de métallisation de ladite pièce moulée pour former les antennes 14, 15, et une étape d'accessoirisation de l'ensemble obtenu afin de fixer notamment le bornier 16 et les composants électroniques sur le circuit électronique 13.

Préférentiellement, les pistes conductrices du circuit électronique 13 sont formées lors de l'étape de métallisation.

On notera que par « dopée », on entend que le polymère utilisé est chargé en particules favorisant le dépôt de métal sur la pièce injectée lors du bain de cette pièce injectée dans un liquide chargé en particules métalliques.

On pourra, à titre d'exemple illustratif, décrire deux méthodes de fabrication de l'interface 10.

La première méthode pouvant être utilisée est communément désignée par l'acronyme LDS (de l'anglais « Laser Direct Structuring »).

Elle comporte en résumé quatre étapes principales.

La première étape consiste à mouler par injection le socle diélectrique 11 dans une matière thermoplastique particulière, à savoir un polymère dopé formé par un complexe organométallique possédant au minimum une liaison métalcarbone.

La seconde étape consiste à activer les zones du socle diélectrique 11 sur lesquelles on souhaite former les antennes 14, 15 et les pistes conductrices du circuit électronique 13. Cette étape d'activation du polymère est effectuée au moyen d'un laser, pour préparer le polymère à recevoir le métal. Elle consiste en l'ablation de ligands organiques à la surface du polymère, de façon à former des microcavités qui permettent ensuite au métal utilisé de s'accrocher mécaniquement au polymère.

La troisième étape consiste en une métallisation de la pièce obtenue afin de former les antennes 14, 15 et les pistes conductrices du circuit électronique 13, via un ou plusieurs bains de métal. Il peut par exemple s'agir d'un bain de cuivre (sans électrolyse) qui permet au cuivre de s'amasser autour des atomes de métal présent à la surface du polymère et de se lier mécaniquement aux microcavités. Une couche de nickel et/ou d'or peut ensuite être appliquée pour éviter toute oxydation. L'épaisseur souhaitée de cuivre peut également être ajustée en multipliant les bains (cette fois avec électrolyse).

La quatrième étape consiste à assembler les composants électroniques (résistances, condensateurs, ...) et le bornier 16 sur les pistes du circuit électrique 13.

La seconde méthode pouvant être utilisée est communément désignée par l'expression anglaise « two-shot » (en français « bi-composants »).

Elle comporte en résumé trois étapes principales.

La première étape consiste en un moulage du support diélectrique 11 sur deux cycles d'injection successifs. Au cours du premier cycle, on injecte dans le moule une résine non dopée qui constitue un substrat. Puis au cours du second cycle, on injecte une résine dopée sur le substrat de manière à ce qu'elle forme le motif des antennes 14, 15 et des pistes conductrices du circuit électronique 13.

La seconde étape est une étape de métallisation, au cours de laquelle la pièce obtenue est plongé dans un bain de métal, de façon à ce quel le métal se dépose par réaction auto-catalytique (réaction chimique avec un catalyseur compris dans la résine dopée utilisée).

La troisième étape consiste à assembler les composants électroniques (résistances, condensateurs, ...) et le bornier 16 sur les pistes du circuit électrique 13.

On notera qu'avec cette seconde méthode il sera possible de créer un support diélectrique 11 en forme de coque creuse, de façon à enfermer si nécessaire le circuit électronique 13 à l'intérieur de cette coque, de manière hermétique.

## Revendications

1. Interface électronique de saisie (10), comprenant :
- un socle diélectrique (11) dont une face (11A) est accessible à l'usager, et
- un détecteur capacitif (12) qui est situé à distance de ladite face (11A) et qui comprend au moins deux antennes (14, 15) distinctes et un circuit électronique (13), lequel circuit électronique (13) est connecté auxdites deux antennes (14, 15) et est adapté à élaborer un signal de détection d'objet,
une partie au moins dudit circuit électronique (13), le socle diélectrique (11) et les deux antennes (14, 15) formant ensemble un dispositif d'interconnexion moulé.

2. Interface électronique de saisie (10) selon la revendication précédente, dans laquelle la face (11A) du socle diélectrique (11) qui est accessible à l'usager présente une forme tridimensionnelle.

3. Interface électronique de saisie (10) selon la revendication précédente, dans laquelle la face (11A) du socle diélectrique (11) qui est accessible à l'usager présente une forme ondulée.

4. Véhicule automobile comprenant un actionneur commandé par une interface électronique de saisie (10), **caractérisé en ce que** ladite interface électronique de saisie (10) est conforme à l'une des revendications précédentes.

5. Véhicule automobile selon la revendication précédente, dans lequel ledit actionneur est adapté à commander la levée et la descente d'une vitre ou la position d'un siège ou la température émise par une climatisation.

6. Procédé de fabrication d'une interface électronique de saisie (10) comprenant un socle diélectrique (11) dont une face (11A) est accessible à l'usager, deux antennes (14, 15) de détecteur capacitif et un circuit électronique (13) qui est connecté auxdites deux antennes (14, 15) et qui est adapté à élaborer un signal de détection d'objet, le procédé comprenant la réalisation d'un ensemble comprenant une partie au moins du circuit électronique (13), le socle diélectrique (11) et les deux antennes (14, 15) au moyen d'une technologie de fabrication de dispositif d'interconnexion moulé, laquelle technologie comprenant une étape d'injection d'une pièce moulée en matière thermoplastique dopée et une étape de métallisation de ladite pièce moulée.

7. Procédé de fabrication selon la revendication précédente, dans lequel il est prévu une étape d'assemblage de composants électroniques et d'un connecteur (16) sur ledit circuit électronique (13).

## Patentansprüche

1. Elektronische Eingabeschnittstelle (10), umfassend:
- einen dielektrischen Sockel (11), von dem eine Fläche (11A) für den Benutzer zugänglich ist, und
- einen kapazitiven Detektor (12), der sich in einem Abstand von der Fläche (11A) befindet und der mindestens zwei gesonderte Antennen (14, 15) und eine elektronische Schaltung (13) umfasst, wobei die elektronische Schaltung (13) an die zwei Antennen (14, 15) angeschlossen ist und geeignet ist, ein Objekterkennungssignal zu erstellen,
wobei wenigstens ein Abschnitt der elektronischen Schaltung (13), der dielektrische Sockel (11) und die zwei Antennen (14, 15) zusammen einen geformten Schaltungsträger bilden.

2. Elektronische Eingabeschnittstelle (10) nach dem vorhergehenden Anspruch, wobei die Fläche (11A) des dielektrischen Sockels (11), die dem Benutzer zugänglich ist, eine dreidimensionale Form aufweist.

3. Elektronische Eingabeschnittstelle (10) nach dem vorhergehenden Anspruch, wobei die Fläche (11A) des dielektrischen Sockels (11), die dem Benutzer zugänglich ist, eine gewellte Form aufweist.

4. Kraftfahrzeug umfassend einen Aktor, der von einer elektronischen Eingabeschnittstelle (10) gesteuert wird, **dadurch gekennzeichnet, dass** die elektronische Eingabeschnittstelle (10) einem der vorhergehenden Ansprüche entspricht.

5. Kraftfahrzeug nach dem vorhergehenden Anspruch, wobei der Aktor geeignet ist, das Anheben und Absenken einer Scheibe oder die Position eines Sitzes oder die Temperatur, die von einer Klimaanlage abgegeben wird, zu steuern.

6. Verfahren zur Fertigung einer elektronischen Eingabeschnittstelle (10), die einen dielektrischen Sockel (11), von dem eine Fläche (11A) für den Benutzer zugänglich ist, zwei Antennen (14, 15) eines kapazitiven Detektors und eine elektronische Schaltung (13), die an die zwei Antennen (14, 15) angeschlossen ist und die geeignet ist, ein Objekterkennungssignal zu erstellen, umfasst, wobei das Verfahren das Herstellen einer Anordnung, die wenigstens einen Abschnitt der elektronischen Schaltung (13), den dielektrischen Sockel (11) und die zwei Antennen (14, 15) umfasst, mittels einer Technologie zur Fertigung eines geformten Schaltungsträgers umfasst, wobei die Technologie einen Schritt des Spritzgießens eines Formteils aus dotiertem thermoplastischem Material und einen Schritt des Metallisierens des Formteils umfasst.

7. Fertigungsverfahren nach dem vorhergehenden Anspruch, wobei ein Schritt des Anbringens elektronischer Bauelemente und eines Konnektors (16) auf der elektronischen Schaltung (13) vorgesehen ist.

## Claims

1. Electronic input interface (10), comprising:
- a dielectric base (11), one face of which (11A) is accessible to the user, and
- a capacitive detector (12) which is located at a distance from said face (11A) and which comprises at least two distinct antennas (14, 15) and an electronic circuit (13), which electronic circuit (13) is connected to said two antennas (14, 15) and is suitable for producing an object detection signal,
at least part of said electronic circuit (13), the dielectric base (11) and the two antennas (14, 15) together forming a moulded interconnection device.

2. Electronic input interface (10) according to the preceding claim, in which the face (11A) of the dielectric base (11) which is accessible to the user has a three-dimensional shape.

3. Electronic input interface (10) according to the preceding claim, in which the face (11A) of the dielectric base (11) which is accessible to the user has a wavy shape.

4. Motor vehicle comprising an actuator controlled by an electronic input interface (10), **characterized in that** said electronic input interface (10) is in accordance with one of the preceding claims.

5. Motor vehicle according to the preceding claim, in which said actuator is suitable for controlling the raising and lowering of a window or the position of a seat or the temperature delivered by air conditioning.

6. Method for producing an electronic input interface (10) comprising a dielectric base (11), one face of which (11A) is accessible to the user, two capacitive detector antennas (14, 15) and an electronic circuit (13) which is connected to said two antennas (14, 15) and which is suitable for producing an object detection signal, the method comprising the production of an assembly comprising at least part of the electronic circuit (13), the dielectric base (11) and the two antennas (14, 15) by means of a technology for producing a moulded interconnection device, which technology comprises a step of injecting a moulded part made of doped thermoplastic material and a step of metallizing said moulded part.

7. Production method according to the preceding claim, in which there is provided a step of assembling electronic components and a connector (16) on said electronic circuit (13).
